# EUROPÄISCHE PATENTSCHRIFT

(11) **EP 2 169 410 B1**
(45) Veröffentlichungstag und Bekanntmachung des Hinweises auf die Patenterteilung: **30.11.2011**
(21) Anmeldenummer: 08017117.6
(22) Anmeldetag: 29.09.2008
(51) Int. Cl.: G01R 11/04, G01R 1/20

(54) **Elektronischer Elektrizitätszähler**
Electronic electricity meter
Compteur électrique électronique

(43) Veröffentlichungstag der Anmeldung: 31.03.2010
(73) Patentinhaber: EMH metering GmbH & Co. KG, 19243 Wittenburg (DE)
(72) Erfinder: Glomski, Mark, 21035 Hamburg (DE)
(74) Vertreter: Hauck Patent- und Rechtsanwälte

(56) Entgegenhaltungen:
- EP-A- 0 612 081
- EP-A- 0 848 258
- EP-B- 1 659 411
- DE-T2- 69 627 449
- DE-U1-202006 017 514
- GB-A- 2 259 783

## Beschreibung

Die Erfindung bezieht sich auf einen elektronischen Elektrizitätszähler nach Patentanspruch 1.

Aus EP 1 657 554 B1 ist ein Elektrizitätszähler bekannt geworden, bei dem das aus Kunststoff bestehende Gehäuse des Zählers ein kastenförmiges Unterteil aufweist, das auf eine Plattform aufsteckbar ausgebildet ist, insbesondere durch Anformung von Hakenabschnitten an der Unterseite des Bodens. Auf die offene Seite des Unterteils wird eine Haube aufgesetzt, die vier Beine aufweist, die in Eckbereichen des Unterteils verriegelt werden. Die Verbindung zwischen Zählerplattform und Gehäuse wird durch ein längliches Plombierelement verriegelt, das von der Vorderseite der Haube durch das Gehäuse hindurch geführt wird bis zur Zählerplattform.

Aus EP 1 659 411 B1 ist ein elektronischer Elektrizitätszähler bekannt geworden, der ein ähnliches Gehäuse aufweist, wie das oben beschriebene. Innerhalb des Gehäuses ist ein skelettartiges Haltebauteil vorgesehen, das innerhalb des Gehäuses festlegbar ist. An dem Haltebauteil ist auf der dem Boden des Gehäuses zugewandten Seite eine Anordnung von drei Fassungen geformt, die Stromsensoren, vorzugsweise blockförmige Kapselungen von Stromwandlern, vorzugsweise klemmend, aufnehmen. Das Haltebauteil weist auf der dem Boden des Gehäuses zugewandten Seite Schlitzabschnitte auf zur Aufnahme von drei Leiterschleifen, die durch jeweils einen Stromsensor geführt sind und deren Enden sich durch Stützen im Boden des Gehäuses in Richtung Zählerplattform erstrecken. Die hier beschriebene Ausführung dient ausschließlich zur Aufnahme von Stromwandlern. Da sich Stromwandler magnetisch beeinflussen lassen, ist es möglich, einen Elektrizitätszähler, der mit Stromwandler ausgerüstet ist z.B. mit starken Dauermagneten messtechnisch so stark zu beeinflussen, dass der Messfehler des Zählers zu zulässigen Verkehrsfehlergrenzen überschreitet. Der Beeinflussbarkeit kann mit Abschirmungen gegen Magnetfelder oder mit Stromsensoren entgegengewirkt werden, die sich magnetisch nicht beeinflussen lassen. Abschirmungen erfordern große Mengen ferromagnetischen Materials, wie z.B. Eisen, das den Zähler schwer und teurer macht. Somit ist ein Stromsensor zu finden, der sich magnetisch überhaupt nicht oder nur sehr wenig beeinflussen lässt. Geeignet ist der Shuntwiderstand, an dem eine dem Messstrom proportionale Spannung abfällt, wie z.B, in DE-U-20 2006 017 514, EP-A-0 848 258, DE-T-696 27 449, EP-A-0 612 081 oder GB-A-2 259 783.

Der Erfindung liegt die Aufgabe zugrunde, einen Elektrizitätszähler der eingangs genannten Art so auszubilden, dass er den Strom nach dem Shunt-Messverfahren ermittelt und auf einfache Weise unter Einhaltung enger Toleranzen für die aus dem Gehäuse ragende Länge der Leiterschleifen nach einem Standard ausgelegt werden kann.

Diese Aufgabe wird durch die Merkmale des Patentanspruchs 1 gelöst.

Bei dem Elektrizitätszähler nach der Erfindung ist die U-förmige Leiterschleife als Stanzteil ausgebildet. Im Gehäuse sind am Boden des Gehäuses angeformte Führungsabschnitte vorgesehen, die Schenkel der Leiterschleife auf gegenüberliegenden Seiten annähernd senkrecht zum Boden führen und begrenzen. Mindestens ein unterer Anschlag dient für die Begrenzung der Leiterschleife nach unten in Richtung Boden, und an einem Führungsabschnitt ist mindestens ein Rastvorsprung geformt, der den Steg der Leiterschleife von oben übergreift.

Durch die Ausbildung der Leiterschleife als beispielsweise Stanzteil lässt sich dieses innerhalb vorgeschriebener Toleranzen zu einem günstigen Preis herstellen. Die Genauigkeit hängt ausschließlich vom Stanzwerkzeug ab. Andere äquivalente Herstellungsverfahren sind auch einsetzbar. Durch die Anordnung der Leiterschleife in der beschriebenen Art und Weise lässt sich ein enger Toleranzrahmen einhalten. Damit ist für die Leiterschleife die exakte Position gewährleistet und nicht von Montagetoleranzen abhängig.

Der erfindungsgemäße Elektrizitätszähler ist als Einphasen-Wechselstromzähler oder auch als Drehstromzähler in Mehrphasennetzen einsetzbar. In letzterem Fall sind drei in parallelen Abständen angeordnete Leiterschleifen vorgesehen, mit Führungsabschnitten, Anschlag und Rastzunge in dreifacher Anordnung. Soll ein derartiges Gehäuseunterteil nur für einen Wechselstromzähler verwendet werden, wird nur eine Leiterschleife montiert. Mit anderen Worten, der erfindungsgemäße Elektrizitätszähler kann sowohl als Einphasen-Wechselstromzähler als auch als Drehstromzähler mit identischen Gehäuse eingesetzt werden.

Nach einer Ausgestaltung der Erfindung ist ein Führungsabschnitt auf einer Seite der Leiterschleife von einem am Boden angeformten Wandabschnitt gebildet, an dem auch der Rastabschnitt geformt ist. Der dem Rastabschnitt gegenüberliegende Führungsabschnitt wird in einer weiteren Ausgestaltung der Erfindung von einem am Boden angeformten Pfosten gebildet.

Die Oberseite von mehreren beabstandeten Wandabschnitten kann als Auflagefläche für eine weitere Leiterplatte dienen. Die Anordnung einer quer im Gehäuse angeordneten Leiterplatte ist aus der bereits erwähnten EP 1 659 411 B1 bekannt. Dort ist sie und das Haltebauteil aufgelegt und mit diesem verbunden. Bei der erfindungsgemäßen Ausgestaltung ist die Leiterplatte auf Wandabschnitten aufsetzbar und durch diese in ihrer Lage gesichert.

Im Zuge der Leiterschleife ist ein Shunt anzuordnen, bei dem der gemessene Spannungsabfall zu dem durchfließenden Strom proportional ist. Bei einer Ausgestaltung der Erfindung ist die Leiterschleife von zwei rechtwinkligen Leiterabschnitten gebildet, von denen zur Bildung einer U-Form jeweils ein Schenkel über ein angeschweißtes bzw. angelötetes Widerstandsplättchen verbunden sind. Das Widerstandsplättchen ist vorzugsweise auf die Schenkel aufliegend mit diesen verbunden. Das Widerstandsplättchen kann bei einer weiteren Ausgestaltung der Erfindung vorzugsweise in einer Ausnehmung des zugeordneten Wandabschnitts aufgenommen sein.

Bei einer anderen Ausgestaltung der Erfindung weist das Widerstandsplättchen Vorsprünge auf, die in Öffnungen einer Leiterplatte eingreifen. Die Leiterplatte enthält die Bauteile, die zur Strommessung erforderlich sind. Sie wird gleichzeitig an der Leiterschleife und einem zugehörigen gegenüberliegenden Führungsabschnitt festgelegt. Vorzugsweise weist die Leiterschleife an den Enden des Steges jeweils einen Vorsprung auf, der ebenfalls mit einer Öffnung der Leiterplatte zusammenwirkt. Dadurch ist die Leiterplatte an vier Punkten in Richtung ihrer Ebene festgelegt, wobei an einem äußeren Vorsprung gleichzeitig eine Spannungsmessung vorgenommen wird. Die Vorsprünge sind vorzugsweise aus dem gestanzten Flachmaterial herausgebogen.

Ein Ausführungsbeispiel der Erfindung wird nachfolgend anhand von Zeichnungen näher erläutert.
- Fig. 1: zeigt perspektivisch teilweise das kastenförmige Unterteil eines Gehäuses eines Elektrizitätszählers mit einer Leiterschleife und einer Leiterplatte.
- Fig. 2: zeigt einen Schnitt durch das Gehäuseunterteil nach Fig. 1 mit einer gegenüberliegenden Ansicht von Leiterschleife und Leiterplatte vor dem endgültigen Einsetzen in das Gehäuseunterteil.
- Fig. 3: zeigt eine ähnliche Darstellung wie Fig. 2, jedoch mit vollständig einge- setzter Leiterschleife, jedoch ohne Leiterplatte.

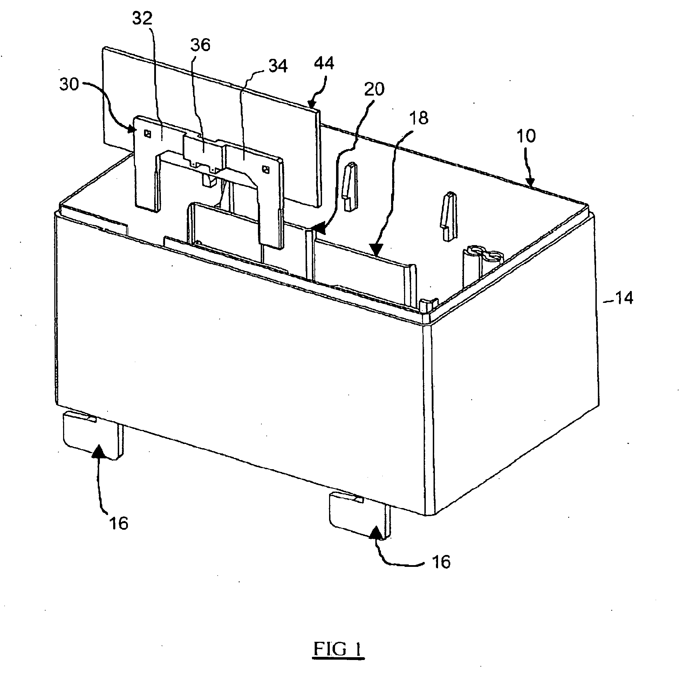

In den Fign. 1 bis 3 ist ein quaderförmiges Unterteil 10 eines Elektrizitätszählers dargestellt mit einem Boden 12 und vier Seitenwänden 14. Auf der Unterseite des Bodens sind in den Eckbereichen vier hakenförmige Abschnitte 16 geformt. Die Hakenabschnitte dienen dazu, das Gehäuseunterteil 10 an einer nicht gezeigten Zählerplattform anzuhängen, welche auch die Anschlüsse für die Versorgungsleitung aufweist. Hierauf wird jedoch nicht weiter eingegangen.

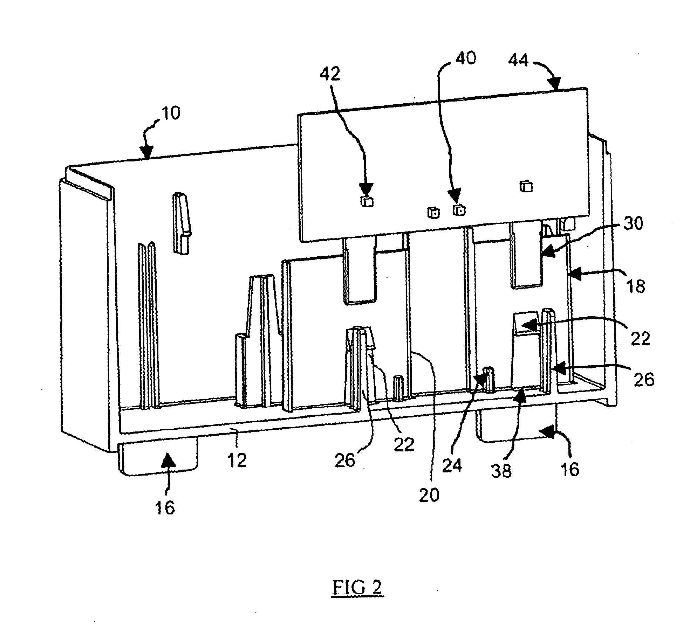

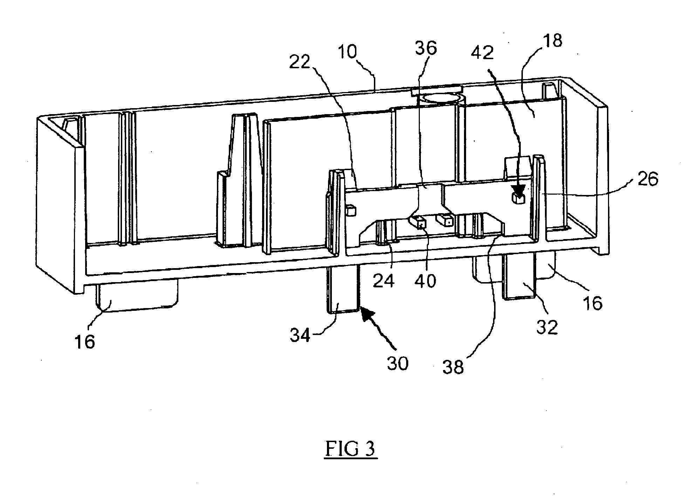

An der Innenseite vom Boden 12 ist ein Wandabschnitt 18 angeformt, der mittig eine sich von oben nach unten erstreckende kanalförmige Ausnehmung 20 aufweist. Auf der in den Fign. 2 und 3 sichtbaren Seite weist der Wandabschnitt 18 auf beiden Seiten der Ausnehmung 20 jeweils eine Rastnase 22 auf. Auf beiden Seiten der kanalförmigen Ausnehmung 20 ist angrenzend an den Wandabschnitt 18 jeweils ein stiftförmiger Anschlag 24 am Boden 12 geformt. Am Boden 12 sind ferner auf der den Rastvorsprüngen 22 zugekehrten Seite des Wandabschnitts 18 pfostenförmige Führungsabschnitte 26 geformt.

In den Fign. 1 bis 3 ist auch eine Leiterschleife 30 zu erkennen. Die Leiterschleife 30 ist aus zwei rechtwinkligen Abschnitten 32, 34 und einem Widerstandsplättchen 36 zusammengesetzt. Das Widerstandsplättchen 36 ist gegen eine Seite der zugeordneten Schenkel der Winkelabschnitte 32, 34 angelegt und mit diesen über eine geeignete Schweiß- oder Lötverbindung verbunden. Das Widerstandsplättchen 36 besteht aus einem geeigneten Widerstandsmaterial, wie es für eine Shuntmessung bei Elektrizitätszählern geeignet ist. Die Winkelabschnitte 32, 34 bestehen aus zum Beispiel Kupfer und sind an den freien Enden mit Zinn beschichtet.

In Fig. 1 besteht die Leiterschleife 30 aus zwei Teilen 32, 34 und einem gekröpften Abschnitt 36, der einen Shunt bildet.

Wie man aus der zusammenschauenden Betrachtung der Figuren erkennt, wird die Leiterschleife 30 mit den freien Enden der Schenkel nach unten weisend zwischen Wandabschnitt 18 und dem Führungspfosten 26 nach unten gesteckt in Durchbrüche bzw. Schlitze 38 im Boden 10, so dass über den Boden 12 nach unten vorstehende Kontaktabschnitte geschaffen sind. Die Leiterschleife 30 ist seitwärts zwischen dem Wandabschnitt 18, vermittelnd durch die Leiterplatte, und den pfostenförmigen Führungen 26 eingeklemmt, wobei die in vertikaler Richtung obere Kante des Stegs der U-förmigen Leiterschleife hinter die Rastnasen 22 schnappt, während die Unterseite des Stegs gegen die Anschläge 24 anliegt. Dadurch ist die Leiterschleife hinsichtlich ihrer Position präzise im Gehäuseunterteil 10 angeordnet. Zur leichteren Einführung der Leiterschleife weisen die Rastnasen 22 an der Oberseite Schrägflächen auf, und die den Rastnasen 22 zugekehrte Seite der Pfosten 26 ist ebenfalls angeschrägt, um ein leichteres Einführen der Schenkel der Leiterschleife zu ermöglichen.

Wie aus Fig. 3 zu erkennen, sind an das Widerstandsplättchen 36 zwei parallele, im Querschnitt rechteckige Anschlussvorsprünge 40 angeformt, die annähernd um 90 gegenüber dem Widerstandsplättchen 36 gebogen sind und sich somit an die Unterseite des Stegs der U-förmigen Leiterschleife angrenzend von dieser fort erstrecken. Im Stegabschnitt der U-förmigen Leiterschleife 30 sind ferner im Endbereich im Querschnitt rechteckige Vorsprünge geformt. Sie sind ebenfalls aus dem Material der Leiterschleife herausgeformt, wie in Fig. 1 zu erkennen (Löcher). Die vier Vorsprünge 40, 42 werden in entsprechende Aufnahmeöffnungen einer Leiterplatte 44 eingesteckt. Die Leiterplatte 44 enthält alle für die Strom- und Spannungsmessung erforderlichen Komponenten und Bauteile.

Beim Einführen von Leiterschleife 30 mit Leiterplatte 44 wird letztere zwischen Leiterschleife 30 und den Pfosten 26 eingeklemmt. Dadurch ist die Leiterplatte sicher im Gehäuseunterteil 10 gehalten.

In den Fign. 1 bis 3 ist jeweils nur eine Leiterschleife dargestellt, wie sie für einen Wechselstromzähler eingesetzt werden kann. Es versteht sich, dass das Gehäuseunterteil 10 auch für einen Drehstromzähler geeignet gemacht werden kann, indem die beschriebenen Teile zur Arretierung der Leiterschleife und der Leiterplatte jeweils dreifach vorhanden sind. Mit anderen Worten, es sind drei parallel angeordnete und beabstandete Wandabschnitte 18 vorhanden, denen jeweils zwei Rastnasen und zwei Pfosten zugeordnet sind.

Nach der beschriebenen Montage kann eine weitere Leiterplatte, welche ein Display enthält und weitere Teile für einen elektronischen Elektrizitätszähler enthält, auf der Oberseite der Wandabschnitte aufgelegt werden, wobei geeignete, jedoch nicht weiter erläuterte Vorsprünge an der Oberseite der Wandabschnitte dafür sorgen, dass die Leiterplatte in ihrer Ebene zu allen Seiten hin festgelegt ist.

## Patentansprüche

1. Elektronischer Elektrizitätszähler mit einem kastenförmigen Gehäuseteil (10), das an der Vorderseite mittels eines Deckels oder dergleichen abschließbar ist und auf der Unterseite seines Bodens Hakenabschnitte (16) aufweist zum Einhaken in eine Zählerplattform, mindestens einer einen Widerstandsabschnitt aufweisenden Leiterschleife (30) innerhalb des Gehäuseteils, deren freie Enden über Durchbrüche (38) im Boden nach außen ragen, zum Kontakt mit einer Versorgungsleitung, und einer mit dem Widerstandsabschnittt (36) elektrisch verbundenen Strommessvorrichtung, wobei im Gehäuseteil am Boden angeformte Führungsabschnitte vorgesehen sind, die Schenkel der Leiterschleife (30) auf gegenüberliegenden Seiten annähernd senkrecht zum Boden (12) führen und begrenzen, mindestens ein unterer Anschlag (20) für einen Steg der Leiterschleife (30) vorgesehen ist und an einem Führungsabschnitt mindestens ein Rastabschnitt (22) geformt ist, der den Steg der Leiterschleife (30) von oben übergreift.

2. Elektrizitätszähler nach Anspruch 1, **dadurch gekennzeichnet, dass** die Leiterschleife (30) U-förmig als Stanzteil ausgebildet ist.

3. Elektrizitätszähler nach Anspruch 1 oder 2, **dadurch gekennzeichnet, dass** für einen Drehstromzähler drei parallel und im Abstand angeordnete Leiterschleifen und Führungsabschnitte vorgesehen sind, sowie der entsprechende Anschlag und Rastvorsprung dreifach vorgesehen sind.

4. Elektrizitätszähler nach einem der Ansprüche 1 bis 3, **dadurch gekennzeichnet, dass** ein Führungsabschnitt auf einer Seite der Leiterschleife (30) von einem am Boden (12) angeformten Wandabschnitt (18) gebildet ist, an dem auch der Rastabschnitt (22) geformt ist.

5. Elektrizitätszähler nach einem der Ansprüche 1 bis 4, **dadurch gekennzeichnet, dass** ein dem Rastabschnitt (22) gegenüberliegender Führungsabschnitt von einem am Boden (12) geformten Pfosten (26) gebildet ist.

6. Elektrizitätszähler nach Anspruch 4 oder 5, **dadurch gekennzeichnet, dass** mehrere beabstandete Wandabschnitte mit ihrer Oberseite eine Auflagefläche für eine weitere Leiterplatte bilden.

7. Elektrizitätszähler nach einem der Ansprüche 1 bis 6, **dadurch gekennzeichnet, dass** die Leiterschleife zwei rechtwinklige Leiterabschnitte aufweist, von denen zur Bildung einer U-Form jeweils Schenkel über ein angeschweißtes bzw. angelötetes Widerstandsplättchen (36) verbunden sind.

8. Elektrizitätszähler nach Anspruch 7, **dadurch gekennzeichnet, dass** das Widerstandsplättchen (36) auf den Schenkeln aufgelegt ist.

9. Elektrizitätszähler nach Anspruch 4 und 8, **dadurch gekennzeichnet, dass** der Wandabschnitt (18) eine Ausnehmung (20) aufweist für die Aufnahme des Widerstandsplättchens (36).

10. Elektrizitätszähler nach einem der Ansprüche 7 bis 9, **dadurch gekennzeichnet, dass** das Widerstandsplättchen (36) Vorsprünge (40) aufweist, die in Öffnungen einer Leiterplatte (44) für die Strommessung eingreifen, wobei die Leiterplatte (44) zwischen der Leiterschleife (30) und dem gegenüberliegenden Führungsabschnitt festgelegt ist.

11. Elektrizitätszähler nach Anspruch 10, **dadurch gekennzeichnet, dass** die Leiterschleife an den Enden des Stegs jeweils einen Vorsprung (42) aufweist, der mit einer Öffnung der Leiterplatte (44) zusammenwirkt.

12. Elektrizitätszähler nach Anspruch 10 oder 11, **dadurch gekennzeichnet, dass** die Vorsprünge aus einem Flachmaterial der Leiterschleife (30) bzw. des Widerstandsplättchens (36) herausgeformt sind.

13. Elektrizitätszähler nach Anspruch 10 und 12, **dadurch gekennzeichnet, dass** die Vorsprünge (40) des Widerstandsplättchens (36) an einer Kante des Widerstandsplättchens (36) abgebogen und mit der Unterseite des Stegs bzw. der den Steg bildenden Schenkel der Leiterschleife verschweißt bzw. verlötet sind.

## Claims

1. An electronic electricity meter with a box-shaped housing part (10), which can be closed on the front side by means of a cover or the like and has hook sections (16) on the bottom side of its base for hooking into a meter platform, at least one conductor loop (30) having a resistance section within the housing part, the free end of which protrudes outward through openings (38) in the base, for contact with a supply line, and a current measurement device electrically connected with the resistance section (36), wherein integrally molded guide sections are provided in the housing part at the base, which guide and restrict legs of the conductor loop (30) on opposite sides almost perpendicular to the base (12), at least one lower stop (20) is provided for a bar of the conductor loop (30) and at least one locking section (22) is formed on a guide section, which overlaps the bar of the conductor loop (30) from above.

2. The electricity meter according to claim 1, **characterized in that** the conductor loop (30) is designed U-shaped as a stamped part.

3. The electricity meter according to claim 1 or 2, **characterized in that** three conductor loops and guide sections arranged in parallel and at a distance are provided for a three-phase current meter, and the corresponding stop and locking projection are provided in triplicate.

4. The electricity meter according to one of claims 1 through 3, **characterized in that** a guide section on one side of the conductor loop (30) is formed by a wall section (18) integrally molded on the base (12), on which the locking section (22) is also formed.

5. The electricity meter according to one of claims 1 through 4, **characterized in that** a guide section lying opposite the locking section (22) is formed by a pillar (26) formed on the base (12).

6. The electricity meter according to claim 4 or 5, **characterized in that** several spaced wall sections with their top side form a bearing surface for another conductor plate.

7. The electricity meter according one of claim 1 through 6, **characterized in that** the conductor loop has two right-angled conductor sections, the legs of each of which arc connected via a welded or respectively soldered resistance plate (36) for the formation of a U shape.

8. The electricity meter according to claim 7, **characterized in that** the resistance plate (36) is placed on the legs.

9. The electricity meter according to claims 4 and 8, **characterized in that** the wall section (18) has a recess (20) for receiving the resistance plate (36).

10. The electricity meter according to one of claims 7 through 9, **characterized in that** the resistance plate (36) has projections (40), which engage in openings of a conductor plate (44) for current measurement, wherein the conductor plate (44) is defined between the conductor loop (30) and the opposite guide section.

11. The electricity meter according to claim 10, **characterized in that** the conductor loop has a projection (42) on each end of the bar, which cooperates with an opening of the conductor plate (44).

12. The electricity meter according to claim 10 or 11, **characterized in that** the projections are formed from a flat material of the conductor loop (30) or respectively the resistance plate (36).

13. The electricity meter according to claim 10 and 12, **characterized in that** the projections (40) of the resistance plate (36) are bent off at one edge of the resistance plate (36) and are welded or respectively soldered with the bottom side of the bar or respectively of the leg of the conductor loop forming the bar.

## Revendications

1. Compteur électrique électronique avec une partie de logement en forme de boîte (10) qui peut être fermée au niveau du côté avant au moyen d'un couvercle ou similaire et présente sur le côté inférieur de son fond des sections de crochet (16) pour l'accrochage dans une plate-forme de compteur, au moins une boucle de conducteur (30) présentant une section de résistance au sein de la partie de logement dont les extrémités libres dépassent vers l'extérieur par le biais de percements (38) dans le fond, pour le contact avec une ligne d'alimentation, et un dispositif de mesure du courant relié électriquement à la section de résistance (36), dans lequel des sections de guidage moulées sur le fond sont prévues dans la partie de logement, lesquelles guident et limitent des branches de la boucle de conducteur (30) sur des côtés opposés de manière approximativement perpendiculaire au fond (12), au moins une butée inférieure (20) pour une traverse de la boucle de conducteur (30) est prévue et au moins une section d'encliquetage (22) est moulée sur une section de guidage, laquelle chevauche la traverse de la boucle de conducteur (30) du haut.

2. Compteur électrique selon la revendication 1, **caractérisé en ce que** la boucle de conducteur (30) est réalisée en forme de U en tant que pièce découpée.

3. Compteur électrique selon la revendication 1 ou 2, **caractérisé en ce que** trois boucles de conducteur et sections de guidage disposées parallèlement et écartées sont prévues pour un compteur triphasé, de même que la butée et saillie d'encliquetage correspondantes sont prévues en triple.

4. Compteur électrique selon l'une quelconque des revendications 1 à 3, **caractérisé en ce qu'**une section de guidage est formée sur un côté de la boucle de conducteur (30) par une section de paroi (18) moulée sur le fond (12) sur laquelle la section d'encliquetage (22) est également moulée.

5. Compteur électrique selon l'une quelconque des revendications 1 à 4, **caractérisé en ce qu'**une section de guidage opposée à la section d'encliquetage (22) est formée par un montant (26) moulé sur le fond (12).

6. Compteur électrique selon la revendication 4 ou 5, **caractérisé en ce que** plusieurs sections de paroi écartées forment avec leur côté supérieur une surface d'appui pour une carte imprimée supplémentaire.

7. Compteur électrique selon l'une quelconque des revendications 1 à 6, **caractérisé en ce que** la boucle de conducteur présente deux sections de conducteur perpendiculaires desquelles des branches sont à chaque fois reliées par le biais d'une plaquette de résistance (36) soudée ou brasée pour la formation d'une forme en U.

8. Compteur électrique selon la revendication 7, **caractérisé en ce que** la plaquette de résistance (36) est posée sur les branches.

9. Compteur électrique selon les revendications 4 et 8, **caractérisé en ce que** la section de paroi (18) présente un évidement (20) pour la réception de la plaquette de résistance (36).

10. Compteur électrique selon l'une quelconque des revendications 7 à 9, **caractérisé en ce que** la plaquette de résistance (36) présente des saillies (40) qui s'engrènent dans des ouvertures d'une carte imprimée (44) pour la mesure du courant, dans lequel la carte imprimée (44) est fixée entre la boucle de conducteur (30) et la section de guidage opposée.

11. Compteur électrique selon la revendication 10, **caractérisé en ce que** la boucle de conducteur présente aux extrémités de la traverse à chaque fois une saillie (42) qui coopère avec une ouverture de la carte imprimée (44).

12. Compteur électrique selon la revendication 10 ou 11, **caractérisé en ce que** les saillies sont moulées à partir d'un matériau plat de la boucle de conducteur (30) ou de la plaquette de résistance (36).

13. Compteur électrique selon les revendications 10 et 12, **caractérisé en ce que** les saillies (40) de la plaquette de résistance (36) sont courbées sur un bord de la plaquette de résistance (36) et sont soudées ou brasées avec le côté inférieur de la traverse ou des branches formant la traverse de la boucle de conducteur.
